# EUROPÄISCHE PATENTSCHRIFT

(11) **EP 3 891 518 B1**
(45) Veröffentlichungstag und Bekanntmachung des Hinweises auf die Patenterteilung: **10.04.2024**
(21) Anmeldenummer: 19816691.0
(22) Anmeldetag: 06.12.2019
(51) Int. Cl.: G01R 31/327

(54) **VORRICHTUNG UND VERFAHREN ZUR VERSCHLEISSERKENNUNG EINER ELEKTROMECHANISCHEN SCHALTEINRICHTUNG**
DEVICE AND METHOD FOR DETECTING WEAR IN AN ELECTROMECHANICAL SWITCHING APPARATUS
SYSTÈME ET PROCÉDÉ DE DÉTECTION D'USURE D'UN DISPOSITIF DE COMMUTATION ÉLECTROMÉCANIQUE

(30) Priorität: 07.12.2018 BE 201805863
(43) Veröffentlichungstag der Anmeldung: 13.10.2021
(73) Patentinhaber: Phoenix Contact GmbH & Co. KG, 32825 Blomberg (DE)
(72) Erfinder: SCHOLZ, Peter, 33034 Brakel (DE); GANSSLOSER, Sören, 72127 Kusterdingen (DE)
(74) Vertreter: Maiwald GmbH
(86) Internationale Anmeldenummer: PCT/EP2019/084060
(87) Internationale Veröffentlichungsnummer: WO 2020/115313

(56) Entgegenhaltungen:
- LIU C ET AL: "Wear prediction of a circuit breaker transmission mechanism with joint clearances considering the atmosphere environment", ZHENDONG YU CHONGJI/JOURNAL OF VIBRATION AND SHOCK, Bd. 37, Nr. 18, 28. September 2018 (2018-09-28), Seiten 67-72, XP002793775, CHINESE VIBRATION ENGINEERING SOCIETY CHN DOI: 10.13465/J.CNKI.JVS.2018.18.009
- PEIDONG ZHUANG ET AL: "A new method of fault diagnosis for HV circuit breakers based on wavelet packet", INDUSTRIAL ELECTRONICS AND APPLICATIONS (ICIEA), 2011 6TH IEEE CONFERENCE ON, IEEE, 21. Juni 2011 (2011-06-21), Seiten 509-513, XP032006071, DOI: 10.1109/ICIEA.2011.5975639 ISBN: 978-1-4244-8754-7
- LIU YAKUI ET AL: "Prediction of the dynamic contact resistance of circuit breaker based on the kernel partial least squares", IET GENERATION, TRANSMISSION&DISTRIBUTION, Bd. 12, Nr. 8, 30. April 2018 (2018-04-30) , Seiten 1815-1821, XP006066882, IET, UK ISSN: 1751-8687, DOI: 10.1049/IET-GTD.2017.1235

## Beschreibung

### Technisches Gebiet

Die vorliegende Erfindung betrifft Systeme für die Überwachung eines Abnutzungsverhaltens.

Insbesondere betrifft die vorliegende Erfindung eine Vorrichtung und ein Verfahren zur Verschleißerkennung einer elektromechanischen Schalteinrichtung.

### Technischer Hintergrund

Im Zuge der vorausschauenden Wartung ist es wichtig, den Zustand von Schaltelementen wie elektromechanischen Relais oder Schützen zu kennen und das gebrauchte oder verschlissene Schaltelement schon vor einem möglichen Ausfall auszutauschen um Stillstand oder Ausfallzeiten zu vermeiden.

In sicherheitsrelevanten Anwendungen kann eine kontinuierliche Zustandsüberwachung von schaltenden Elementen noch deutlich wichtiger sein.

In der DE 10 2016 124083 B4 wird ein Relais überwacht, indem eine mechanische und eine elektrische Zustandsgröße ermittelt und über ein Kennlinienfeld der Zustand des Relais ermittelt wird.

In der DE 10 2018 114 425 A1 wird eine Schaltüberwachungsvorrichtung vorgestellt, die den Schaltzeitpunkt des Relais auf der Spulenseite (galvanische Trennung) unabhängig von der Belastung des Kontaktes detektieren kann

Weitere relevante Stand der Technik Dokumente sind: LIU C ET AL: "Wear prediction of a circuit breaker transmission mechanism with joint clearances considering the atmosphere environment",ZHENDONG YU CHONGJI/JOURNAL OF VIBRATION AND SHOCK, Bd. 37, Nr. 18, 28. September 2018 (2018-09-28), Seiten 67-72, CHINESE VIBRATION ENGINEERING SOCIETY CHN DOI: 10.13465/J.CNKI.JVS.2018.18.009; PEIDONG ZHUANG ET AL: "A new method of fault diagnosis for HV circuit breakers based on wavelet packet", INDUSTRIAL ELECTRONICS AND APPLICATIONS (ICIEA), 2011 6TH IEEE CONFERENCE ON, IEEE, 21. Juni 2011 (2011-06-21), Seiten 509-513, DOI: 10.1109/ICIEA.2011.5975639ISBN: 978-1-4244-8754-7; und LIU YAKUI ET AL: "Prediction of the dynamic contact resistance of circuit breaker based on the kernel partial least squares",IET GENERATION, TRANSMISSION&DISTRIBUTION, Bd. 12, Nr. 8, 30. April 2018 (2018-04-30), Seiten 1815-1821, IET, UK ISSN: 1751-8687, DOI: 10.1049/IET-GTD.2017.1235.

### Zusammenfassung der Erfindung

Es ist eine Aufgabe der vorliegenden Erfindung, eine verbesserte Vorrichtung und ein verbessertes Verfahren zur Verschleißerkennung breitzustellen.

Diese Aufgabe wird durch die Gegenstände der unabhängigen Patentansprüche gelöst. Weiterbildungen und Ausführungsformen sind den abhängigen Patentansprüchen, der Beschreibung und den Figuren der Zeichnungen zu entnehmen.

Ein erster Aspekt der vorliegenden Erfindung betrifft eine Vorrichtung zur Verschleißerkennung einer elektromechanischen Schalteinrichtung, wobei die Vorrichtung eine Messeinrichtung und eine Auswerteeinrichtung umfasst:
Die Messeinrichtung ist dazu ausgebildet, mindestens einen vorbestimmten Betriebsparameter der elektromechanischen Schalteinrichtung zu erfassen.

Die Auswerteeinrichtung ist dazu ausgebildet, anhand eines maschinellen Tiefenlernen-Verfahrens unter Zuhilfenahme von Massendaten, vorzugsweise in Form von Trainingsdaten, aus dem erfassten vorbestimmten Betriebsparameter der elektromechanischen Schalteinrichtung einen aktuellen Verschleißzustand der elektromechanischen Schalteinrichtung zu ermitteln.

Die vorliegende Erfindung ermöglicht, den Zustand von elektromechanischen Schalteinrichtungen, wie beispielsweise ein elektromechanisches Relais oder Schaltschütz, zu bestimmen und das gebrauchte oder verschlissene Schaltelement schon vor einem drohenden, möglichen Ausfall auszutauschen, um eine Stillstandzeit zu minieren oder das Auftreten eines Stillstands zu verhindern oder sonstige Störungen zu vermeiden.

Die vorliegende Erfindung ermöglicht, dass eine Alterung von einer elektromechanischen Schalteinrichtung mit minimalem Messaufwand zuverlässig bestimmt wird.

Die vorliegende Erfindung ermöglicht durch Methoden der künstlichen Intelligenz, wie maschinelles Lernen oder wie Künstliche neuronale Netze, auch künstliche neuronale Netzwerke, basierend auf in einem Anlernprozess verwendeten Trainingsdaten Vorhersagen zu aktuellen Messdaten zu treffen.

Mit auf Englisch sogenannten "Deep Learning"-Methoden, auf Deutsch etwa "tiefgehendes Lernen", nachfolgend auch als maschinelles Tiefenlernen-Verfahren" bezeichnet, wird beispielsweise eine Klasse von Optimierungsmethoden künstlicher neuronaler Netze definiert, die zahlreiche Zwischenlagen - englisch "hidden layers" - zwischen Eingabeschicht und Ausgabeschicht haben und dadurch eine umfangreiche innere Struktur aufweisen.

Dies ermöglicht vorteilhaft, dass keine manuelle Merkmalsextraktion bzw. Festlegung von überwachten Merkmalen benötigt wird. Daher können präzise Vorhersagen getroffen werden, wenn die Modelle mit Massendaten, auf Englisch auch "Big Data", in der Form von Trainingsdaten trainiert werden, wobei hier auch eine Markierung der Trainingsdaten mit Zustandsdaten der elektromechanischen Schalteinrichtungen erfolgen kann, d.h. referenziert oder gelabelt.

Gemäß einer Ausführungsform der vorliegenden Erfindung werden hierzu viele Relais mit vielen verschiedenen Lasten in vielen verschiedenen Einsatzszenarien vermessen und der aktuelle Zustand, etwa Verschleiß, Temperatur, Schaltzyklus, aktuelle Last, dokumentiert bzw. gelabelt.

Wenn beispielsweise ein Relais nach 100.000 Schaltzyklen defekt ist und alle Schaltzyklen zuvor aufgenommen und gespeichert worden sind, kann die vorliegende erfindungsgemäße Vorrichtung bzw. das erfindungsgemäße Verfahren ermitteln, dass dieses spezielle Relais bei dem 50.000 Schaltzyklus ca. 50% gealtert ist, wenn man eine lineare Alterung bei gleichbleibender Last zugrunde legt. Somit können nach dem Defekt des Relais die in der Vergangenheit aufgenommenen Daten von 100.000 Schaltzyklen dokumentiert und individuell mit einem Labeln, etwa Grad der Alterung von 0% bis 100%, versehen und als Trainingsdaten verwendet werden.

Demzufolge wird beispielsweise in einer Ausführungsform der vorliegenden Erfindung ein neuronales Netz mit einer Auswahl aus gelabelten 100.000 Schaltzyklen trainiert und wenn das neuronale Netz später einen ähnlichen Schaltzyklus wie der zuvor erwähnte 50.000 Schaltzyklus als einen aktuellen Schaltzyklus von einem anderen Relais vergleichbaren Typs erfasst, kann das neuronale Netz schätzen, dass dieses Relais auch zu etwa 50% verschlissen ist, auch wenn das andere Relais zu diesem Zeitpunkt vielleicht nur 1.000 Schaltzyklen mit einer anderen Last durchlaufen hat.

In dem neuronalen Netz wird jedoch kein direkter Vergleich von den Schaltzyklen miteinander durchgeführt, sondern durch Optimierungsverfahren im Trainingsprozess hat das Verfahren selber gelernt bzw. die internen Parameter so optimiert, dass relevante Merkmale, die für den Verschleiß charakteristisch sind, implizit im neuronalen Netz enthalten sind und somit Prognosen zu aktuellen unbekannten Eingangsdaten ausgegeben werden können.

Das in der Auswerteeinrichtung implementierte neuronale Netz ist in einer Ausführungsform der vorliegenden Erfindung zuvor trainiert worden und ist durch die Auswertung von aktuellen Messungen in der Lage, auf den aktuellen Zustand des aktuell verbauten Relais zu schließen, den Verschleißzustand zu ermitteln.

Das in der Auswerteeinrichtung implementierte neuronale Netz kann auch die Einsatzhistorie der elektronischen Schalteinrichtung mitberücksichtigen, beispielsweise kann zugrunde gelegt werden, dass ein Relais typischerweise mit fortschreitender Zeit nicht besser, sondern eher schlechter wird, d.h. ein Verschleiß grundsätzlich immer zunimmt. Hierfür können sogenannte rekurrente neuronale Netze zum Einsatz kommen oder andere Verfahren verwendet werden.

Vorteilhafte Ausgestaltungen der vorliegenden Erfindung sind den Unteransprüchen zu entnehmen.

In einer vorteilhaften Ausführungsform der vorliegenden Erfindung ist vorgesehen, dass die Auswerteeinrichtung dazu ausgebildet ist, basierend auf dem ermittelten aktuellen Verschleißzustand und den Massendaten eine Prädiktion für den zukünftigen Abnutzungsverlauf der elektromechanischen Schalteinrichtung zu ermitteln.

Dies ermöglicht vorteilhaft auch Voraussagen über die Entwicklung des zukünftigen Verschleißes und der zu erwartenden Abnutzung der elektromechanischen

Schalteinrichtung bereitzustellen.

Wenn beispielsweise die Last des Relais mehr oder weniger konstant ist, in der Vergangenheit typischerweise 1.000 Schaltzyklen pro Woche aufgetreten sind, das Relais aktuell den 40.000 Schaltzyklus durchläuft, ein aktueller Verschleiß von 80% durch die Auswerteeinheit geschätzt worden ist und eine lineare Alterung vorausgesetzt wird, kann in einer einfachen Hochrechnung geschlussfolgert werden, dass von einer Restlebensdauer des Relais von ca. 10.000 Schaltspielen bzw. 10 Wochen ausgegangen werden kann. Selbstverständlich können auch komplexere Alterungsmodelle verwendet werden.

In einer vorteilhaften Ausführungsform der vorliegenden Erfindung ist vorgesehen, dass die Vorrichtung dazu ausgebildet ist, die Massendaten mit einer Zuordnung zu einem jeweiligen Zustand der elektromechanischen Schalteinrichtung bereitzustellen; wobei vorzugsweise die Messeinrichtung einen Prozessor aufweist.

In einer vorteilhaften Ausführungsform der vorliegenden Erfindung ist vorgesehen, dass die Messeinrichtung ferner dazu ausgebildet ist, über eine Datenschnittstelle einen Datenstrom umfassend den erfassten mindestens einen vorbestimmten Betriebsparameter zu übermitteln; wobei vorzugsweise die Messeinrichtung ferner dazu ausgebildet ist, mit einer Energieversorgungseinrichtung gekoppelt zu werden und/oder über ein Ansteuersignal der elektromechanischen Schalteinrichtung mit Energie versorgt zu werden.

In einer vorteilhaften Ausführungsform der vorliegenden Erfindung ist vorgesehen, dass die Vorrichtung eine Vielzahl an Messeinrichtungen aufweist und die Auswerteeinrichtung dazu ausgebildet ist, den aktuellen Verschleißzustand einer Vielzahl an elektromechanischen Schalteinrichtungen basierend auf einer Vielzahl an erfassten vorbestimmten Betriebsparametern zu ermitteln.

In einer vorteilhaften Ausführungsform der vorliegenden Erfindung ist vorgesehen, dass die Auswerteeinrichtung als eine dezentrale Computerumgebung, verteilt über ein Rechnernetz ausgebildet ist, wobei vorzugsweise die Vorrichtung ferner dazu ausgebildet ist, über einen Übertragungskanal Daten über den aktuellen Verschleißzustand an die elektromechanische Schalteinrichtung zu übertragen.

In einer vorteilhaften Ausführungsform der vorliegenden Erfindung ist vorgesehen, dass die Messeinrichtung dazu ausgebildet ist, in einem Relaissockel für die elektromechanische Schalteinrichtung integriert zu werden.

In einer vorteilhaften Ausführungsform der vorliegenden Erfindung ist vorgesehen, dass die Auswerteeinrichtung dazu ausgebildet ist, in einem Relaissockel für die elektromechanische Schalteinrichtung integriert zu werden, wobei vorzugsweise die Auswerteeinrichtung ferner dazu ausgebildet ist, als ein gemeinsames Kopfmodul für eine Vielzahl von in weiteren Relaissockeln integrierten Messeinrichtung für weitere elektromechanische Schalteinrichtungen verwendet zu werden.

In einer vorteilhaften Ausführungsform der vorliegenden Erfindung ist vorgesehen, dass die Vorrichtung ferner eine Anzeigeneinrichtung umfasst, welche vorzugsweise dazu ausgebildet ist, den aktuellen Verschleißzustand der elektromechanischen Schalteinrichtung anzuzeigen.

In einer vorteilhaften Ausführungsform der vorliegenden Erfindung ist vorgesehen, dass der mindestens eine vorbestimmte Betriebsparameter der elektromechanischen Schalteinrichtung eine Betätigungskraft, eine Gegenkraft, einen Betätigungsweg, einen Überhub, einen Schaltpunkt, einen Lichtimpuls, einen Lichtbogen, ein akustisches Signal, ein Magnetfeld, eine Temperatur, einen Spulenstrom, eine Spulenspannung, einen Kontaktstrom, einen Laststrom oder eine Kontaktspannung umfasst.

In einer vorteilhaften Ausführungsform der vorliegenden Erfindung ist vorgesehen, dass die Massendaten beliebige Betriebsparameter umfassen und die beliebigen Betriebsparametereine Betätigungskraft, eine Gegenkraft, einen Betätigungsweg, einen Überhub, einen Schaltpunkt, einen Lichtimpuls, einen Lichtbogen, ein akustisches Signal, ein Magnetfeld, eine Temperatur, einen Spulenstrom, eine Spulenspannung, einen Kontaktstrom, einen Laststrom oder eine Kontaktspannung der elektromechanischen Schalteinrichtung umfassen.

In einer vorteilhaften Ausführungsform der vorliegenden Erfindung ist vorgesehen, dass die Messeinrichtung dazu ausgebildet ist, die beliebigen Betriebsparameter als Kennlinien basierend auf einer Vorabmessung während einer Initialisierungsphase der elektromechanischen Schalteinrichtung zu erfassen.

In einer vorteilhaften Ausführungsform der vorliegenden Erfindung ist vorgesehen, dass die Auswerteeinrichtung dazu ausgebildet ist, bei dem maschinellen Tiefenlernen (i) eine Merkmalsextraktion aus den Massendaten und/oder (ii) eine Merkmalsklassifizierung der Massendaten zu verwenden.

In einer vorteilhaften Ausführungsform der vorliegenden Erfindung ist vorgesehen, dass die Auswerteeinrichtung ein neuronales Netz, eine Stützvektormaschine, einen Klassifikator und/oder einen Regressor aufweist.

In einer vorteilhaften Ausführungsform der vorliegenden Erfindung ist vorgesehen, dass die Auswerteeinrichtung dazu ausgebildet ist, basierend auf einer Vielzahl von erfassten vorbestimmten Betriebsparameter einen individuellen Abnutzungskurvenverlauf der elektromechanischen Schalteinrichtung zu bestimmen und darauf basierend auf einen Typenparameter der jeweiligen elektromechanischen Schalteinrichtung zu schließen.

In einer vorteilhaften Ausführungsform der vorliegenden Erfindung ist vorgesehen, dass die Messeinrichtung dazu ausgebildet ist, einen Umgebungsparameter der elektromechanischen Schalteinrichtung und/oder einen Typenparameter der elektromechanischen Schalteinrichtung, vorzugsweise in der Form eines Herstellercodes, zu erfassen.

In einer vorteilhaften Ausführungsform der vorliegenden Erfindung ist vorgesehen, dass die Auswerteeinrichtung dazu ausgebildet ist, basierend auf dem Umgebungsparameter der elektromechanischen Schalteinrichtung und/oder dem Typenparameter der elektromechanischen Schalteinrichtung den aktuellen Verschleißzustand der elektromechanischen Schalteinrichtung zu ermitteln.

In einem zweiten Aspekt der vorliegenden Erfindung ist ein zur Verschleißerkennung einer elektromechanischen Schalteinrichtung, wobei das Verfahren folgenden Verfahrensschritte umfasst:
Als ein erster Verfahrensschritt erfolgt ein Erfassen von mindestens einem vorbestimmten Betriebsparameter der elektromechanischen Schalteinrichtung mittels einer Messeinrichtung.

Als ein zweiter Verfahrensschritt erfolgt ein Ermitteln eines aktuellen Verschleißzustandes der elektromechanischen Schalteinrichtung anhand eines maschinellen Tiefenlernen-Verfahrens unter Zuhilfenahme von Massendaten, vorzugsweise in Form von Trainingsdaten, aus dem erfassten vorbestimmten Betriebsparameter der elektromechanischen Schalteinrichtung mittels einer Auswerteeinrichtung.

Als ein dritter Verfahrensschritt erfolgt optional ein Ermitteln einer Prädiktion für den zukünftigen Abnutzungsverlauf der elektromechanischen Schalteinrichtung basierend auf den Massendaten und den mittels der Auswerteeinrichtung.

Nach einem dritten Aspekt umfasst die vorliegende Erfindung ein Computerprogramm oder ein Computerprogrammprodukt, umfassend Befehle, die bei der Ausführung des Programms durch einen Computer diesen veranlassen, dass die Schritte des Verfahrens nach dem zweiten Aspekt oder einer beliebigen Ausführungsform des zweiten Aspektes ausgeführt werden.

Nach einem vierten Aspekt umfasst die vorliegende Erfindung ein Computerlesbares Speichermedium, umfassend Befehle, die bei der Ausführung durch einen Computer diesen veranlassen, die Schritte des Verfahrens nach dem zweiten Aspekt oder einer beliebigen Ausführungsform des zweiten Aspektes ausgeführt werden.

Die beschriebenen Ausgestaltungen und Weiterbildungen lassen sich beliebig miteinander kombinieren.

Weitere mögliche Ausgestaltungen, Weiterbildungen und Implementierungen der vorliegenden Erfindung umfassen auch nicht explizit genannte Kombinationen von zuvor oder im Folgenden bezüglich der Ausführungsformen beschriebenen Merkmale der vorliegenden Erfindung.

Die beiliegenden Zeichnungen sollen ein weiteres Verständnis der Ausführungsformen der vorliegenden Erfindung vermitteln.

Die beiliegenden Zeichnungen veranschaulichen Ausführungsformen und dienen im Zusammenhang mit der Beschreibung der Erklärung von Konzepten der vorliegenden Erfindung.

Andere Ausführungsformen und viele der genannten Vorteile ergeben sich im Hinblick auf die Figuren der Zeichnungen. Die dargestellten Elemente der Figuren der Zeichnungen sind nicht notwendigerweise maßstabsgetreu zueinander gezeigt.

### Kurze Beschreibung der Figuren

Es zeigen:
- Fig. 1:: eine schematische Darstellung einer Vorrichtung zur Verschleißerkennung einer elektromechanischen Schalteinrichtung gemäß einem Ausführungsbeispiel der vorliegenden Erfindung; und
- Fig. 2:: eine schematische Darstellung eines Flussdiagramms eines Verfahrens zur Verschleißerkennung einer elektromechanischen Schalteinrichtung gemäß einem Ausführungsbeispiel der vorliegenden Erfindung;
- Fig. 3:: eine schematische Darstellung einer Vorrichtung zur Verschleißerkennung einer elektromechanischen Schalteinrichtung gemäß einem Ausführungsbeispiel der vorliegenden Erfindung;
- Fig. 4:: eine schematische Darstellung von Diagrammen zur Verschleißerkennung einer elektromechanischen Schalteinrichtung gemäß einem Ausführungsbeispiel der vorliegenden Erfindung;
- Fig. 5:: eine schematische Darstellung eines Diagramms zur Verschleißerkennung einer elektromechanischen Schalteinrichtung gemäß einem Ausführungsbeispiel der vorliegenden Erfindung.

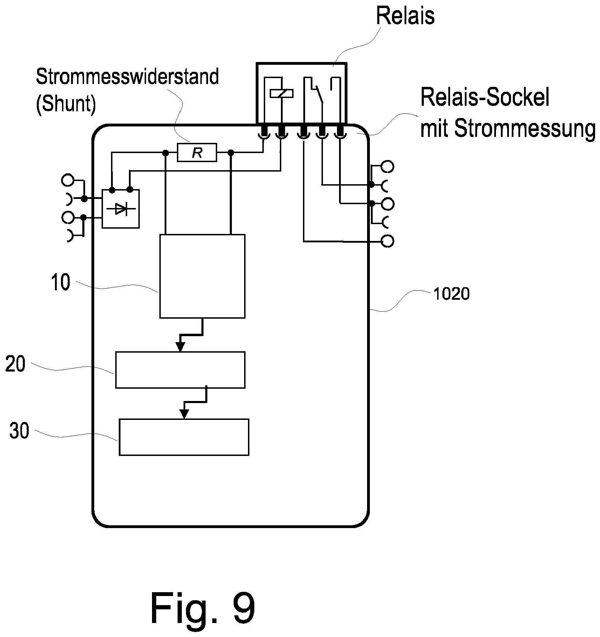

- Fig. 6-9:: je eine schematische Darstellung einer Vorrichtung zur Verschleißerkennung einer elektromechanischen Schalteinrichtung gemäß einem Ausführungsbeispiel der vorliegenden Erfindung; und
- Fig. 10:: eine schematische Darstellung eines Diagramms zur Verschleißerkennung einer elektromechanischen Schalteinrichtung mit einer weiteren Messeinrichtung gemäß einem Ausführungsbeispiel der vorliegenden Erfindung.

### Detaillierte Beschreibung der Ausführungsbeispiele

In den Figuren der Zeichnungen bezeichnen gleiche Bezugszeichen gleiche oder funktionsgleiche Elemente, Bauteile, Komponenten oder Verfahrensschritte, soweit nichts Gegenteiliges angegeben ist.

Der Begriff "Künstliches neuronales Netz" wie von der vorliegenden Erfindung verwendet umfasst beispielsweise ein Rechnernetz basierend auf einer Sammlung von miteinander verbundenen Einheiten oder Knoten, die als künstliche Neuronen bezeichnet werden und die Neuronen in einem biologischen Gehirn lose modellieren.

Der Begriff "rekurrentes neuronales Netz" wie von der vorliegenden Erfindung verwendet umfasst beispielsweise ein neuronales Netz, das sich im Gegensatz zu einem normalen, auch als Feedforward-Netz bezeichneten Netz durch Verbindungen von Neuronen einer Schicht zu Neuronen derselben oder einer vorangegangenen Schicht auszeichnet.

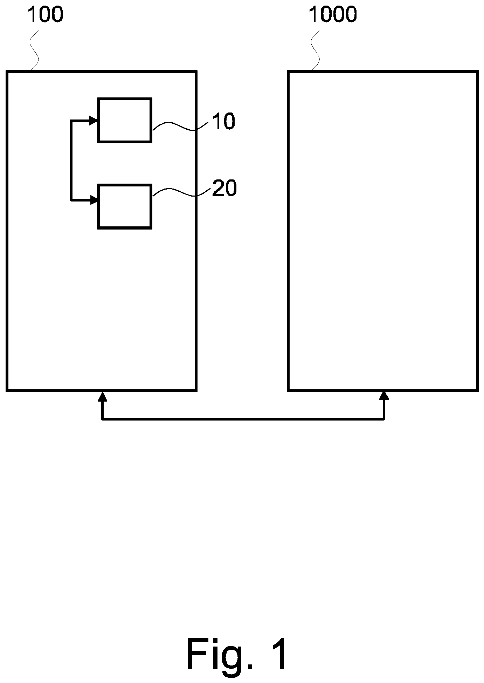

Die Fig. 1 zeigt eine schematische Darstellung einer Vorrichtung zur Verschleißerkennung einer elektromechanischen Schalteinrichtung gemäß einem Ausführungsbeispiel der vorliegenden Erfindung.

Die Vorrichtung 100 umfasst eine Messeinrichtung 10 und eine Auswerteeinrichtung 20.

Die Messeinrichtung 10 ist dazu ausgebildet, mindestens einen vorbestimmten Betriebsparameter der elektromechanischen Schalteinrichtung zu erfassen.

Die Auswerteeinrichtung 20 ist dazu ausgebildet, anhand eines maschinellen Tiefenlernen-Verfahrens unter Zuhilfenahme von Massendaten, vorzugsweise in Form von Trainingsdaten, aus dem erfassten vorbestimmten Betriebsparameter der elektromechanischen Schalteinrichtung einen aktuellen Verschleißzustand der elektromechanischen Schalteinrichtung zu ermitteln.

Das vorliegende Verfahren ermöglicht eine Verschleißerkennung, d.h. eine Überwachung einer Abnutzung bzw. des Abnutzungsverhaltens eines elektromechanischen Schaltgerätes, bereitzustellen.

Die Messeinrichtung 10 ist beispielsweise als eine Messvorrichtung zum Detektieren eines Betriebsparameters ausgebildet, wie etwa ein Ereignis, d.h. etwa ein Schaltvorgang des elektromechanischen Schaltgerätes, eine Temperaturerhöhung des elektromechanischen Schaltgerätes, oder auch eine Entfernung oder ein Ausfall des elektromechanischen Schaltgerätes in Form des Relais.

Die Messeinrichtung 10 ist beispielsweise als eine Messvorrichtung zur Detektion eines Kurvenverlaufes und/oder einer oder mehrerer charakteristischer Größen des Ereignisses ausgebildet.

Die Auswerteeinrichtung 20 ist beispielsweise dazu ausgebildet, ein Zuordnen von digitalen repräsentativen Daten zu dem aktuellen Ereignis bzw. dem aktuellen Betriebsparameter vorzunehmen.

Es kann ferner ein Einspielen der repräsentativen Daten und/oder der Trainingsdaten und/oder von Zustandsdaten in das künstliche neuronale Netz erfolgen.

Das Ereignis bzw. der Betriebsparameter kann beispielsweise ein Spulenstrom im Einschaltmoment sein, es können auch mehrere elektrische oder physikalische Größen zu einem Betriebsparameter zusammengefasst werden, etwa Spulenstrom und Kontaktspannung. Als Betriebsparameter kann auch ein berechneter Wert wie beispielsweise ein ermittelter Überhub sein.

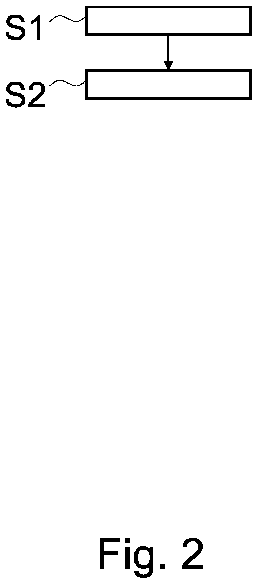

Die Fig. 2 zeigt eine schematische Darstellung eines Flussdiagramms eines Verfahrens zur Verschleißerkennung einer elektromechanischen Schalteinrichtung gemäß einem Ausführungsbeispiel der vorliegenden Erfindung.

Als ein erster Verfahrensschritt erfolgt ein Erfassen S1 von mindestens einem vorbestimmten Betriebsparameter der elektromechanischen Schalteinrichtung mittels einer Messeinrichtung.

Als ein zweiter Verfahrensschritt erfolgt ein Ermitteln S2 eines aktuellen Verschleißzustandes der elektromechanischen Schalteinrichtung anhand eines maschinellen Tiefenlernen-Verfahrens unter Zuhilfenahme von Massendaten, vorzugsweise in Form von Trainingsdaten, aus dem erfassten vorbestimmten Betriebsparameter der elektromechanischen Schalteinrichtung mittels einer Auswerteeinrichtung.

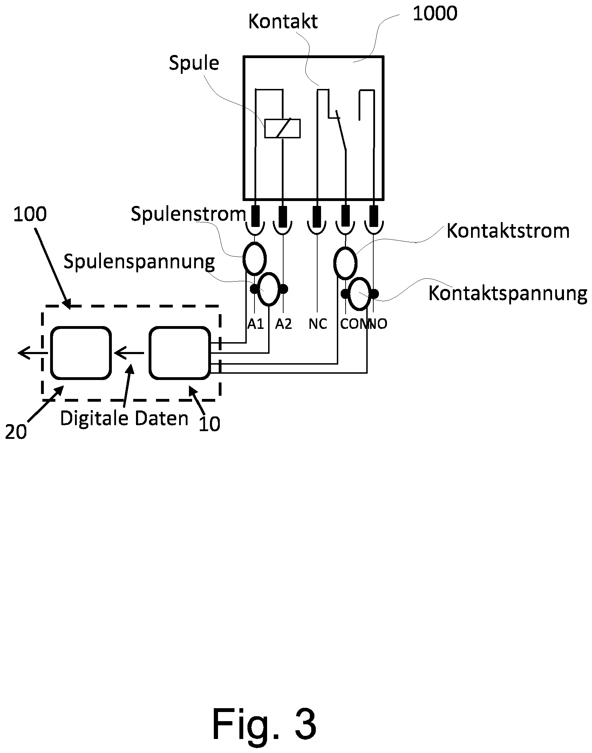

Die Fig. 3 zeigt eine Vorrichtung zur Verschleißerkennung einer elektromechanischen Schalteinrichtung gemäß einem Ausführungsbeispiel der vorliegenden Erfindung.

Das in der Fig. 3 gezeigte Vorrichtung stellt einen Messaufbau des erfindungsgemäßen Verfahrens dar. Ein Relais oder ein Schütz oder ein elektromechanisches Schaltgerät hat im inneren eine Spule verbaut, die mit einer Spannung über Kontakte beaufschlagt werden kann.

Gemäß einem Ausführungsbeispiel der vorliegenden Erfindung, sobald eine Spannung an der Spule anliegt, beginnt ein Strom durch die Spule zu fließen, ein Magnetfeld wird aufgebaut, eine Kraft auf einen Anker wird ausgeübt und der Anker bewegt einen Kontakt derart, dass ein elektrischer Kontakt geschlossen oder geöffnet wird, je nach Typ, Öffner oder Schließer. Eine Kombination aus Öffner und Schließer wird als Wechsler bezeichnet.

Gemäß einem Ausführungsbeispiel der vorliegenden Erfindung kann dabei die vorliegende Erfindung für beliebige Relais oder andere elektromechanische Schaltgerate anwendbar sein.

Die vorliegende Erfindung ermöglicht, dass man charakteristische elektrische Größen des Relais erfasst und auswertet.
gemäß einem Ausführungsbeispiel der vorliegenden Erfindung können beispielsweise in direkter Messung wie in Figur 3 dargestellt die folgenden elektrischen oder physikalischen Größen als erfasste Größe bzw. Betriebsparameter verwendbar sein:
i) Spulenstrom
ii) Spulenspannung
iii) Kontaktstrom bzw. Laststrom
iv) Kontaktspannung bzw. Lastspannung

Gemäß einem Ausführungsbeispiel der vorliegenden Erfindung können auch andere Kenngrößen, wie etwa ein Schaltzeitpunkt oder ein Kontaktwiderstand über andere, hierzu geeignete elektrische Schaltungen gemessen werden.

Gemäß einem Ausführungsbeispiel der vorliegenden Erfindung können auch andere Messgrößen erfasst werden, beispielsweise indem man versucht, optisch einen möglichen Lichtbogen am Kontakt beim Öffnen zu detektieren oder durch einen Magnetfeldsensor Aussagen über das Magnetfeld in der Spule zu treffen.

Gemäß einem Ausführungsbeispiel der vorliegenden Erfindung werden die gemessenen Größen anschließend von einer oder mehreren Messvorrichtungen in Form der Messeinrichtung 10 erfasst und dabei auch digitalisiert.

Gemäß einem Ausführungsbeispiel der vorliegenden Erfindung können dabei weitere Informationen, wie beispielsweise ein Zeitstempel oder Zählerstände hinzugefügt werden, die indirekt gemessen werden.

Gemäß einem Ausführungsbeispiel der vorliegenden Erfindung können die digitalen Daten kontinuierlich vorliegen basierend auf einer kontinuierlich vorgenommenen Messung oder sinnvollerweise nur bei Schaltereignissen aktualisiert werden basierend auf einer durch unterschiedliche Triggerungen vorgenommenen Messung.

Gemäß einem Ausführungsbeispiel der vorliegenden Erfindung kann vorzugsweise beispielsweise die Kontaktspannung nur dann übermittelt werden, wenn auch ein Schaltereignis vorliegt. In der Zeit zwischen Ein- und Ausschaltvorgang, d.h. während der leitenden Phase, ist der Informationsgehalt der Kontaktspannung gegebenenfalls nicht aussagekräftig, da bei einem ausreichend guten Zustand des Kontakts eine Kontaktspannung nahe Null zu erwarten ist.

Im Ausschaltmoment wiederum kann der Informationsgehalt der Kontaktspannung sehr informativ sein, da darin beispielsweise Informationen über eine Ausbildung eines Lichtbogens in der Folge von Abnutzungserscheinung der Kontaktflächen enthalten sein können, was auf einen gewissen Materialabbrand und somit einen Verschleiß schließen lässt.

Gemäß einem Ausführungsbeispiel der vorliegenden Erfindung werden die digitalen Daten somit nur bei jedem Schaltvorgang aktualisiert, mit anderen Worten, die Messeinrichtung 10 ist beispielsweise dazu ausgebildet, durch einen Schaltvorgang getriggert zu werden, eine Messung vorzunehmen, wobei auch eine Intervallauslösung der Messung vorgesehen sein kann.

Gemäß einem Ausführungsbeispiel der vorliegenden Erfindung werden nur jeder zweite Schaltvorgang, jeder 10. Schaltvorgang oder 100. Schaltvorgang ausgewertet.

Gemäß einem Ausführungsbeispiel der vorliegenden Erfindung wird eine Aktualisierung pro Zeiteinheit, etwa pro Minute oder pro Stunde oder einmal am Tag vorgenommen und eine Messung durch die Messeinrichtung 10 vorgenommen, mit anderen Worten, eine zeitliche Intervallschaltung wird vorgesehen.

Wenn eine Temperaturüberwachung vorliegt, können die digitalen Daten auch zwischen Schaltvorgängen aktualisiert werden, beispielsweise wenn das Relais in leitender Phase dauerhaft eine überhöhte Last schaltet, also außerhalb seiner Spezifikationen betrieben wird.

Gemäß einem Ausführungsbeispiel der vorliegenden Erfindung werden die digitalen Daten nach der Aktualisierung an das oben beschriebene künstliche neuronale Netz in der Auswerteeinrichtung 20 zugeführt.

Das künstliche neuronale Netz erhält nun gemäß einem Ausführungsbeispiel der vorliegenden Erfindung diese digitalen Daten und kann daraus nach einer Berechnung den Zustand des Relais prognostizieren.

Gemäß einem Ausführungsbeispiel der vorliegenden Erfindung sind mögliche Ausgabemöglichkeiten des künstlichen neuronalen Netzes beispielsweise:
i) "Das Relais ist zu 70% verschlissen"
ii) "Der Relaistyp ist XXX oder YYY"
iii) "Das Relais ist an einer kleinen / mittleren / großen / zu großen Last angeschlossen"
iv) "Die voraussichtliche Restlebensdauer ist 3 Jahre und 2 Monate"
v) "Die Temperatur im Relais ist geschätzt zwischen 70°C und 80°C"
vi) "Achtung: Es besteht die Gefahr, dass das Relais bald verklebt"

Aus bereits gelernten Daten in der Trainingsphase kann das neuronale Netz gegebenenfalls anhand von Kurvenverläufen auf den Relaistyp schießen.

Die Bestimmung der Last kann beispielsweise über die Alterungshistorie und der Auswertung der bereits durchlaufenen Schaltzyklen ermittelt werden, beispielsweise wenn ein Relais nach 1.000 Zyklen bereits 30% Verschleiß aufweist, ist die zu schaltende Last wohl eher zu groß und es wird weiter mit einer erhöhten Abnutzung in der Zukunft für eine gleichbleibende Last zu rechnen sein.

Gemäß einem Ausführungsbeispiel der vorliegenden Erfindung, wenn der Laststrom gemessen wird, kann gegebenenfalls auch hierüber eine Aussage über die Art der Last getroffen werden, beispielsweise induktiv und/oder kapazitiv und/oder ohmsch getroffen werden.

Gemäß einem Ausführungsbeispiel der vorliegenden Erfindung, wenn die Last mehr oder weniger konstant bleibt und das Schaltintervall einem festen Zyklus folgt, kann die Auswerteeinrichtung 20 dazu ausgebildet sein, dass gegebenenfalls eine Restlebensdauer prognostiziert wird.

Gemäß einem Ausführungsbeispiel der vorliegenden Erfindung kann gegebenenfalls aus Messungen am Kontakt ermittelt werden, welche Restlebensdauer noch vorhanden ist, oder wenn sich die Form des Spulenstroms signifikant ändert, kann hierauf auch eine Abnutzung ermittelt werden.

Gemäß einem Ausführungsbeispiel der vorliegenden Erfindung kann gegebenenfalls ermittelt werden, ob der gemessene Spulenstrom trotz anliegender Spannung Null oder annähernd Null ist. Daraus kann gegebenenfalls auf einen Defekt der Spule geschlossen oder geschlussfolgert werden, dass keine Spule angeschlossen ist.

Gemäß einem Ausführungsbeispiel der vorliegenden Erfindung kann aus dem Verlauf des Spulenstroms ein temperaturabhängiger Widerstand oder eine Induktivität bestimmt werden.

Gemäß einem Ausführungsbeispiel der vorliegenden Erfindung kann alternativ auch die Temperatur direkt über einen Temperaturfühler gemessen werden.

Gemäß einem Ausführungsbeispiel der vorliegenden Erfindung kann beispielsweise ein Abgleich von charakteristischen Mustern in den Messdaten erfolgen oder in den davon abgeleiteten Daten, die beispielsweise während eine Ein- oder des Ausschaltvorgangs gemessen werden.

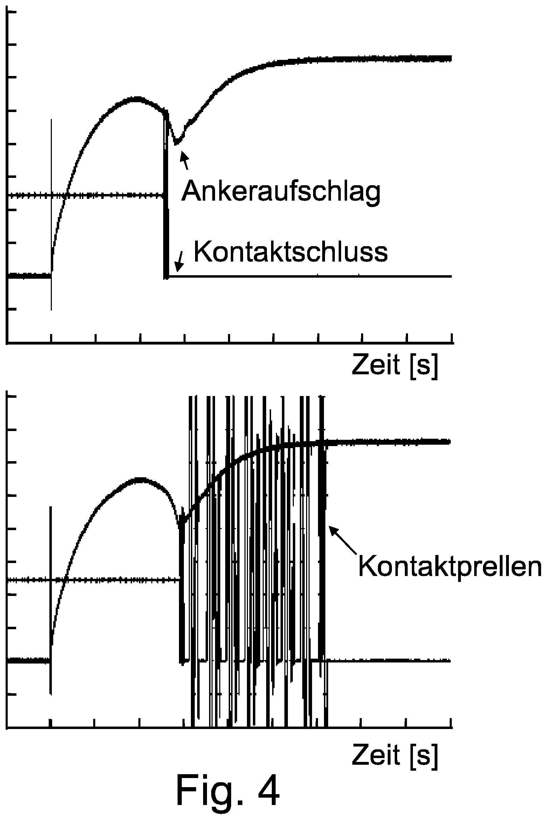

In der Figur 4 sind Kurvenverläufe der gemessenen Größen beispielhaft dargestellt. Es handelt sich dabei um einen Einschaltmoment, also zum Zeitpunkt t=0 wird eine Spannung sprunghaft an die Spule gelegt und auf einem konstanten Wert gehalten.

Auf dem oberen Diagramm sind die Kurvenverlaufe für ein neues Relais dargestellt, während auf dem unteren Diagramm die Kurvenverläufe eines stark gealterten Relais dargestellt sind.

Obwohl hier stochastische Prozesse eine Rolle spielen und auch zwei direkt hintereinander folgende Einschaltmomente der selben elektromechanischen Schalteinrichtung deutlich voneinander abweichen können, sind dennoch wiederkehrende Schaltereignisse in einer korrespondierenden Phase des Abnutzungsverlaufs der elektromechanischen Schalteinrichtung ähnlich und die Werte wandern im Laufe der Zeit langsam in eine Richtung.

Aus den Kurvenverlaufen können nun automatisiert charakteristische Merkmale abgeleitet werden. Ein beispielhafter Parameter bzw. ein Merkmal ist der so genannte Überhub, der sich in den Zeiten zwischen dem Kontaktschluss und dem Ankeraufschlag wiederspiegelt.

Der Überhub ist eigentlich eine Strecke, die in mm gemessen wird, aufgrund einer Geschwindigkeit des Ankers in m/s bzw. mm/ms kann ein ähnliches charakteristisches Merkmal aber auch in ms ausgedrückt werden. Diese Größe wird in diesem Kontext auch als Überhub bezeichnet. Es wird also die Zeitspanne zwischen dem ersten Kontaktschluss und dem Ankeraufschlag aus den Kurvenverläufen abgelesen, dabei kann man für jeden Einschaltvorgang einen zeitlichen Überhub bestimmen.

Wie anhand der beiden Diagramme erkennbar ist, unterscheiden sich die Kurvenverläufe eines neuen und eines stark gealterten Relais typischerweise deutlich voneinander.

So ist beispielsweise bei dem stärker gealterten Relais ein deutlich erhöhtes Kontaktprellen festzustellen.

Es ist nun eine Aufgabe des künstlichen neuronalen Netzes aus diesen Daten einen Abnutzungsgrad zu erkennen und zu quantifizieren.

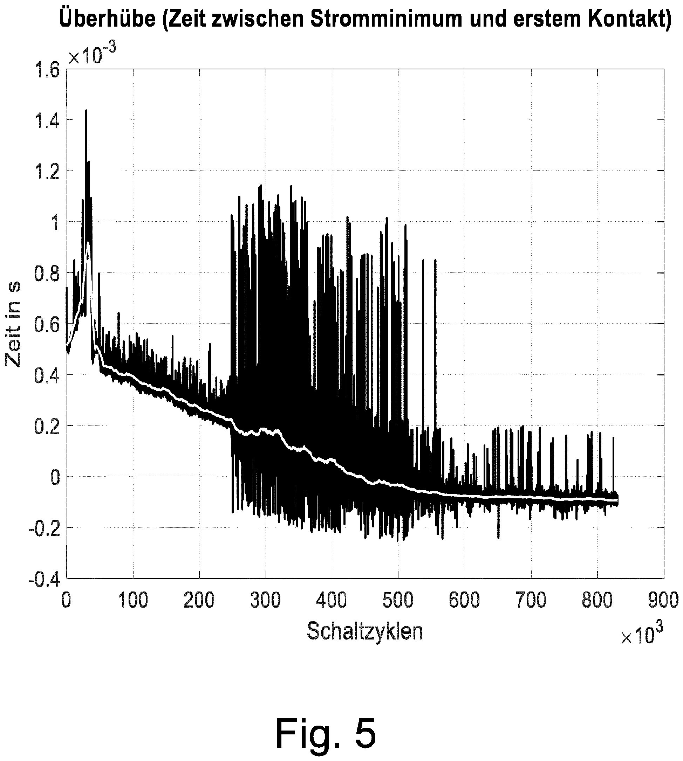

In Figur 5 ist ein Diagramm dargestellt und der gemessene zeitliche Überhub über die Lebensdauer aufgetragen. Man erkennt zwar eine generelle abfallende Tendenz des Überhubs im Laufe des Lebenszyklus der elektromechanischen Schalteinrichtung 1000, es wird aber auch deutlich, dass die einzelnen Messwerte stark verrauscht sind.

Man kann also nicht einfach den Überhub messen und daraus abschätzen, wie stark das Relais abgenutzt ist.

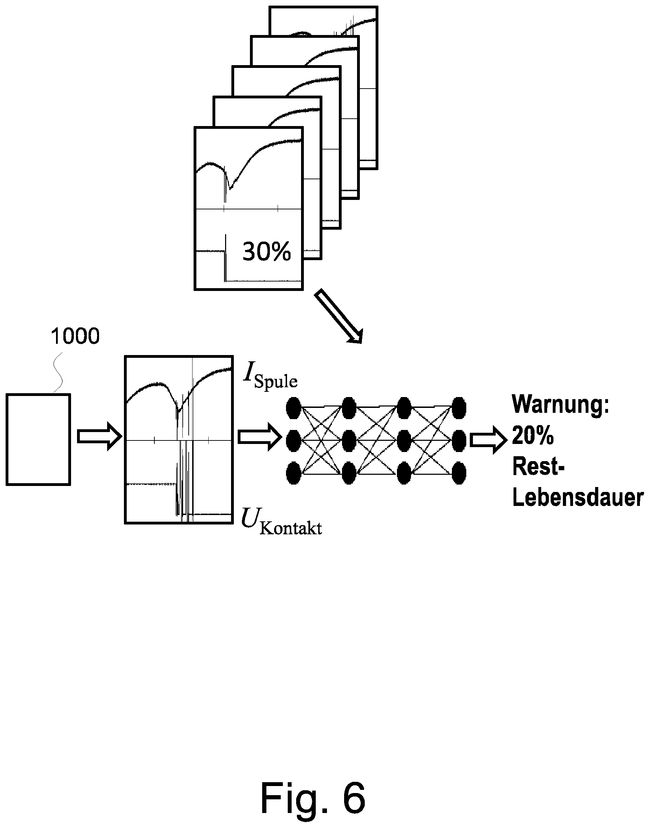

In Figur 6 ist die erfindungsgemäße Losung noch einmal bildlich dargestellt. Die gemessenen Kurvenverläufe werden in ein zuvor trainiertes neuronales Netz gegeben, das anhand von zuvor erlernten Kurven eine Prognose über den Zustand des Relais abgeben kann.

Das neuronale Netz wurde zuvor mit gelabelten - mit einem Zusatz versehen - Daten trainiert. Es wurden wiederholt Messungen in das Netz gegeben und zu jeder Messung gesagt, wie stark das Relais in dieser Messung tatsächlich gealtert ist. Das neuronale Netz sucht im Optimierungsprozess in der Lernphase nun selbständig nach charakteristischen Merkmalen, die für die Alterung verantwortlich sind.

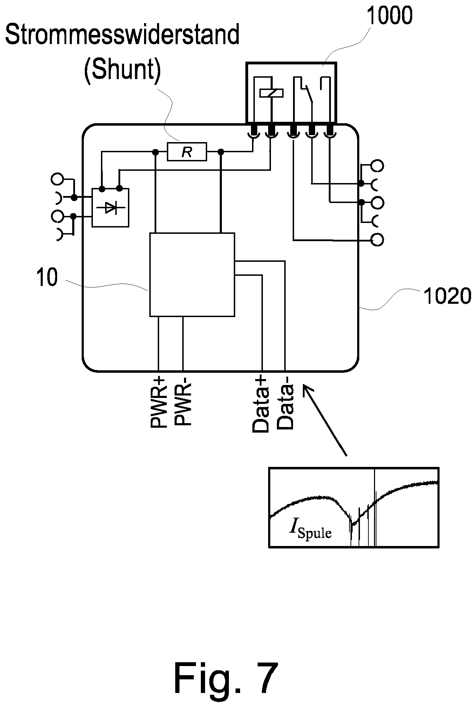

In Figur 7 ist ein Ausführungsbeispiel eines erfindungsgemäßen Aufbaus skizziert. Hier kommt ein Relais-Sockel 1020 zum Einsatz, der den Spulenstrom über einen Messwiderstand, auch als Shunt bezeichnet, in eine Spannung umwandelt und über eine Messvorrichtung, beispielsweise ein Analog-Digital-Wandler, ADC, A/D-Wandler, englisch ADC - "analog-to-digital converter" - misst und digitalisiert.

Ein Prozessor kann die digitalen Stromdaten In einen Datenstrom umwandeln und über eine Schnittstelle, bezeichnet mit "Data+" "Data-", weiterleiten.

Es können zusätzliche Daten hinzugefügt werden wie beispielsweise Zeitstempel, Temperaturen etc. Die Hilfsenergie kann entweder von extern, bezeichnet mit "PWR+" und "PWR-", hinzugefügt werden oder sie wird aus dem Spulenansteuerungssignal gewonnen.

Wenn dieser Fall gewählt wird, ist darauf zu achten, dass die Energieversorgung nur dann sichergestellt ist, wenn auch eine Spannung an den Anschlüssen anliegt. Ferner kann auch über einen Pufferkondensator Energie zwischengespeichert werden, um die Daten auch noch nach einem Messvorgang übertragen zu können.

Das neuronale Netz, das in diesem Ausführungsbeispiel außerhalb des Relaissockels implementiert ist, hat in diesem Ausführungsbeispiel die Aufgabe nur aus dem Spulenstrom und ggf. wenigen Zusatzinformationen auf den Zustand des Relais zu schließen.

Der Überhub kann in diesem Fall beispielsweise nicht direkt berechnet werden. Dies ist aber auch nicht zwingend erforderlich, da das Neuronale Netz die relevanten Merkmale selbständig ermittelt.

Gemäß einem Ausführungsbeispiel ist die Datenschnittstelle derart ausgelegt, dass die Messdaten an eine Cloud übermittelt werden, in der das neuronale Netz gepflegt und ausgeführt wird. Dort sind dann alle Informationen über das Relais vereinbar. Ggf. gibt es einen optionalen Rückkanal, um beispielsweise den Zustand visuell am Relaissockel darzustellen.

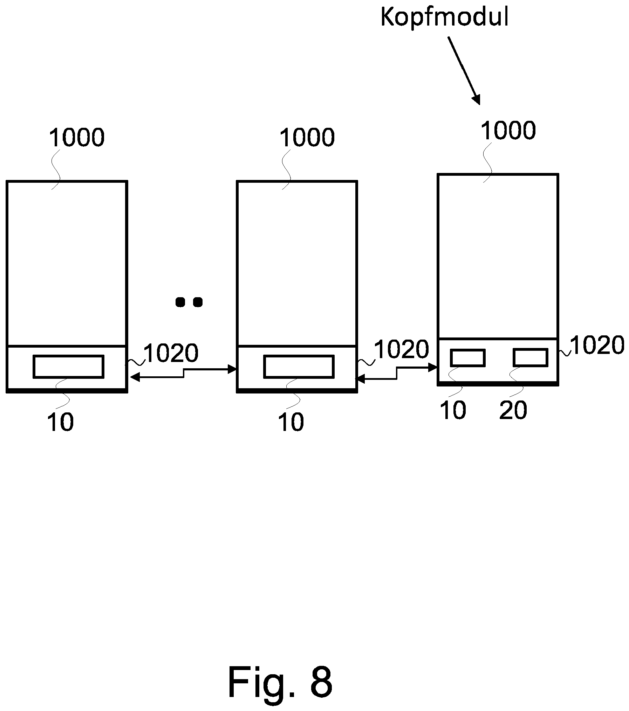

In Figur 8 sind mehrere Relaissockel 1020 über einen lokalen Kommunikationsbus miteinander verbunden und die einzelnen Messdaten der Relais-Sockel 1020 werden von einem zentralen Kopfmodul verwaltet.

In dem Kopfmodul kann dann das neuronale Netz ausgeführt werden, das alle an einem lokalen Bus angeschlossenen Relais überwacht. Das Kopfmodul kann mit einer weiteren Datenschnittstelle ausgestattet sein, um die gewonnen Daten extern weiterzugeben.

Es kann auch sein, dass vom Kopfmodul die Daten der einzelnen Relais nur gesammelt werden und dass das neuronale Netz auf einem externen Gerat ausgewertet und verwaltet wird.

Es können alternativ auch nur eine Datenvorverarbeitung oder Teile des neuronalen Netzes in dem Kopfmodul verarbeitet werden und andere Teile in einem externen Gerat.

Das Kopfmodul kann in einer weiteren Ausführungsform auch derart ausgestaltet sein, dass keine eigene elektromechanischen Schalteinrichtung 100) und keine eigene Messeinrichtung 10 direkt daran angeschlossen werden, sondern dass durch das Kopfmodul die Daten nur eingesammelt und wie oben beschrieben weiterverarbeitet werden.

Gemäß einem Ausführungsbeispiel der vorliegenden Erfindung kann das neuronale Netz auch einen Prozessor oder einen Mikroprozessor beinhalten.

Gemäß einem Ausführungsbeispiel der vorliegenden Erfindung umfasst die Vorrichtung ferner eine Anzeigeneinrichtung 30, die in Form einer mehrschichtigen Anzeige oder einer Ampelform dargestellt werden kann.

Es können beispielsweise die folgende Falle visualisiert werden:
- Klasse 1: Neues Produkt ("new")
- Klasse 2: Produkt in Gebrauch ("in use")
- Klasse 3: Abgenutztes Produkt ("worn")
- Klasse 4: Lebensende naht ("end of life")

Es kann bei diesem Ausführungsbeispiel vorgesehen sein, dass das eingesetzte Relais mit dem Relais-Sockel gekoppelt wird, also beispielsweise bereits direkt nach der Produktion und vor der Auslieferung des Produktes an den Kunden einige Schaltzyklen durchlaufen werden und das neuronale Netz genau für dieses Relais eine Feinabstimmung erhält.

Sollte später ein neues Relais in den Sockel eingesetzt werden, könnte das neuronale Netz beispielsweise kurzfristig auf das neue Relais nachtrainiert werden.

Dies kann in einer sogenannten Initialisierungsphase geschehen. Es ist auch denkbar, dass Zusatzinformation über das Relais (beispielsweise Herstellercode) händische in den Relais-Sockel eingegeben werden, beispielsweise über eine zusätzliche Datenschnittstelle, damit die Prognose des neuronalen Netzes verbessert wird.

Die zusätzliche optionale Datenschnittstelle kann vorgesehen sein, um gewonnene Informationen über den Zustand des Relais nicht nur direkt am Relais darzustellen, sondern in ein übergeordnetes Netzwerk bereitzustellen. Es ist aber auch vorstellbar, dass über die Schnittstelle "Updates" oder Datenbestandsänderungen in den Relais-Sockel übertragen werden, beispielsweise wenn eine neue Version des neuronalen Netzes vorliegt.

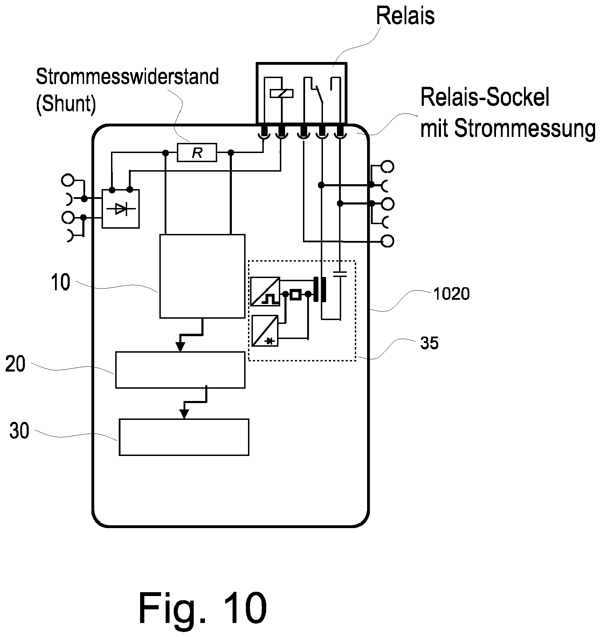

In Figur 10 ist eine Abwandlung von dem Relais-Sockel dargestellt, wobei gezeigt wird, dass neben dem Spulenstrom auch noch andere Messtechnik in dem Relais-Sockel integriert sein kann. Die Möglichkeiten sind hier vielfaltig und kurz in der Figur 10 beschrieben.

So ist es beispielsweise möglich, dass die Steuerung in der Form der Auswerteeinrichtung 20 das Einschaltsignal der elektromechanischen Schalteinrichtung 1000 erhält und ihrerseits die Spule der elektromechanischen Schalteinrichtung 1000ansteuert.

Dadurch kann eine zusätzliche Flexibilität gewonnen werden, beispielsweise könnte die Spule besonders Relais-schonend angesteuert werden oder auf einen geeigneten Einschaltzeitpunkt gewartet werden, beispielsweise bei AC Anwendungen, hier kann es beispielsweise sinnvoll sein, auf einen Stromnulldurchgang am Kontakt zu warten bevor das Relais eingeschaltet wird.

Dabei kann vorteilhaft die in der Figur 10 dargestellte Schaltungstechnik zum Einsatz kommen, um Informationen zum Schaltzeitpunkt des Kontaktes zu erhalten, ohne eine aufwändige direkte Messtechnik auf der Kontaktseite bereitzustellen.

Obwohl die vorliegende Erfindung anhand bevorzugter Ausführungsbeispiele vorstehend beschrieben wurde, ist sie nicht darauf beschränkt, sondern auf vielfältige Art und Weise modifizierbar. Insbesondere lässt sich die Erfindung in mannigfaltiger Weise verändern oder modifizieren, ohne von den angehängten Ansprüchen abzuweichen.

Ergänzend sei darauf hingewiesen, dass "umfassend" und "aufweisend" keine anderen Elemente oder Schritte ausschließt und "eine" oder "ein" keine Vielzahl ausschließt.

Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

## Patentansprüche

1. Vorrichtung (100) zur Verschleißerkennung einer elektromechanischen Schalteinrichtung (1000), wobei die Vorrichtung (100) umfasst:
- eine Messeinrichtung (10), welche dazu ausgebildet ist, mindestens einen vorbestimmten Betriebsparameter der elektromechanischen Schalteinrichtung (1000) zu erfassen; und
- eine Auswerteeinrichtung (20), welche dazu ausgebildet ist, anhand eines maschinellen Tiefenlernen-Verfahrens unter Zuhilfenahme von Massendaten, vorzugsweise in Form von Trainingsdaten, aus dem erfassten vorbestimmten Betriebsparameter der elektromechanischen Schalteinrichtung (1000) einen aktuellen Verschleißzustand der elektromechanischen Schalteinrichtung (1000) zu ermitteln.

2. Vorrichtung (100) nach Patentanspruch 1,
wobei die Auswerteeinrichtung (20) dazu ausgebildet ist, basierend auf dem ermittelten aktuellen Verschleißzustand und den Massendaten eine Prädiktion für den zukünftigen Abnutzungsverlauf der elektromechanischen Schalteinrichtung (1000) zu ermitteln.

3. Vorrichtung (100) nach Patentanspruch 1 oder 2,
wobei die Vorrichtung (100) dazu ausgebildet ist, die Massendaten mit einer Zuordnung zu einem jeweiligen Zustand der elektromechanischen Schalteinrichtung (1000) bereitzustellen;
wobei vorzugsweise die Messeinrichtung (10) einen Prozessor aufweist.

4. Vorrichtung (100) nach einem der vorhergehenden Patentansprüche,
wobei die Messeinrichtung (10) ferner dazu ausgebildet ist, über eine Datenschnittstelle einen Datenstrom umfassend den erfassten mindestens einen vorbestimmten Betriebsparameter zu übermitteln; wobei vorzugsweise die Messeinrichtung (10) ferner dazu ausgebildet ist, mit einer Energieversorgungseinrichtung gekoppelt zu werden und/oder über ein Ansteuersignal der elektromechanischen Schalteinrichtung (1000) mit Energie versorgt zu werden.

5. Vorrichtung (100) nach einem der vorhergehenden Patentansprüche,
wobei die Vorrichtung (100) eine Vielzahl an Messeinrichtungen (10) aufweist und die Auswerteeinrichtung (20) dazu ausgebildet ist, den aktuellen Verschleißzustand einer Vielzahl an elektromechanischen Schalteinrichtungen (1000) basierend auf einer Vielzahl an erfassten vorbestimmten Betriebsparametern zu ermitteln.

6. Vorrichtung (100) nach einem der vorhergehenden Patentansprüche,
wobei die Auswerteeinrichtung (20) als eine dezentrale IT-Infrastruktur, verteilt über ein Rechnernetz ausgebildet ist, wobei vorzugsweise die Vorrichtung (100) ferner dazu ausgebildet ist, über einen Übertragungskanal Daten über den aktuellen Verschleißzustand an die elektromechanische Schalteinrichtung (1000) zu übertragen.

7. Vorrichtung (100) nach einem der vorhergehenden Patentansprüche,
wobei die Messeinrichtung (10) dazu ausgebildet ist, in einem Relaissockel für die elektromechanische Schalteinrichtung (1000) integriert zu werden; und/oder
wobei die Auswerteeinrichtung (20) dazu ausgebildet ist, in einem Relaissockel für die elektromechanische Schalteinrichtung (1000) integriert zu werden, wobei vorzugsweise die Auswerteeinrichtung (20) ferner dazu ausgebildet ist, als ein gemeinsames Kopfmodul für eine Vielzahl von in weiteren Relaissockeln integrierten Messeinrichtung (10) für weitere elektromechanische Schalteinrichtungen (1000) verwendet zu werden.

8. Vorrichtung (100) nach einem der vorhergehenden Patentansprüche,
wobei die Vorrichtung (100) ferner eine Anzeigeneinrichtung umfasst, welche vorzugsweise dazu ausgebildet ist, den aktuellen Verschleißzustand der elektromechanischen Schalteinrichtung anzuzeigen.

9. Vorrichtung (100) nach einem der vorhergehenden Patentansprüche,
wobei der mindestens eine vorbestimmte Betriebsparameter der elektromechanischen Schalteinrichtung (1000) eine Betätigungskraft, eine Gegenkraft, einen Betätigungsweg, einen Überhub, einen Schaltpunkt, einen Lichtimpuls, einen Lichtbogen, ein akustisches Signal, ein Magnetfeld, eine Temperatur, einen Spulenstrom, eine Spulenspannung, einen Kontaktstrom, einen Laststrom oder eine Kontaktspannung umfasst; und/oder
wobei die Massendaten beliebige Betriebsparameter umfassen und die beliebigen Betriebsparametereine Betätigungskraft, eine Gegenkraft, einen Betätigungsweg, einen Überhub, einen Schaltpunkt, einen Lichtimpuls, einen Lichtbogen, ein akustisches Signal, ein Magnetfeld, eine Temperatur, einen Spulenstrom, eine Spulenspannung, einen Kontaktstrom, einen Laststrom oder eine Kontaktspannung der elektromechanischen Schalteinrichtung (1000) umfassen.

10. Vorrichtung (100) nach einem der vorhergehenden Patentansprüche,
wobei die Messeinrichtung (10) dazu ausgebildet ist, die beliebigen Betriebsparameter als Kennlinien basierend auf einer Vorabmessung während einer Initialisierungsphase der elektromechanischen Schalteinrichtung (1000) zu erfassen.

11. Vorrichtung (100) nach einem der vorhergehenden Patentansprüche,
wobei die Auswerteeinrichtung (20) dazu ausgebildet ist, bei dem maschinellen Tiefenlernen (i) eine Merkmalsextraktion aus den Massendaten und/oder (ii) eine Merkmalsklassifizierung der Massendaten zu verwenden.

12. Vorrichtung (100) nach einem der vorhergehenden Patentansprüche,
wobei die Auswerteeinrichtung (20) ein neuronales Netz, eine Stützvektormaschine, einen Klassifikator und/oder einen Regressor aufweist.

13. Vorrichtung (100) nach einem der vorhergehenden Patentansprüche,
wobei die Auswerteeinrichtung (20) dazu ausgebildet ist, basierend auf einer Vielzahl von erfassten vorbestimmten Betriebsparameter einen individuellen Abnutzungskurvenverlauf der elektromechanischen Schalteinrichtung (1000) zu bestimmen und darauf basierend auf einen Typenparameter der jeweiligen elektromechanischen Schalteinrichtung (1000) zu schließen.

14. Vorrichtung (100) nach einem der vorhergehenden Patentansprüche,
wobei die Messeinrichtung (10) dazu ausgebildet ist, einen Umgebungsparameter der elektromechanischen Schalteinrichtung (1000) und/oder einen Typenparameter der elektromechanischen Schalteinrichtung (1000), vorzugsweise in der Form eines Herstellercodes, zu erfassen; und
wobei die Auswerteeinrichtung (20) dazu ausgebildet ist, basierend auf dem Umgebungsparameter der elektromechanischen Schalteinrichtung (1000) und/oder dem Typenparameter der elektromechanischen Schalteinrichtung (1000) den aktuellen Verschleißzustand der elektromechanischen Schalteinrichtung (1000) zu ermitteln.

15. Verfahren zur Verschleißerkennung einer elektromechanischen Schalteinrichtung (1000), wobei das Verfahren folgende Verfahrensschritte umfasst:
- Erfassen (S1) von mindestens einem vorbestimmten Betriebsparameter der elektromechanischen Schalteinrichtung (1000) mittels einer Messeinrichtung (10); und
- Ermitteln (S2) eines aktuellen Verschleißzustandes der elektromechanischen Schalteinrichtung (1000) anhand eines maschinellen Tiefenlernen-Verfahrens unter Zuhilfenahme von Massendaten, vorzugsweise in Form von Trainingsdaten, aus dem erfassten vorbestimmten Betriebsparameter der elektromechanischen Schalteinrichtung (1000) mittels einer Auswerteeinrichtung (20).

## Claims

1. Device (100) for detecting wear of an electromechanical switching device (1000), the device (100) comprising:
- a measuring device (10) which is adapted to detect at least one predetermined operating parameter of the electromechanical switching device (1000); and
- an evaluation device (20) which is adapted to determine a current state of wear of the electromechanical switching device (1000) from the recorded predetermined operating parameter of the electromechanical switching device (1000) using a machine deep learning method with the aid of mass data, preferably in the form of training data.

2. Device (100) according to claim 1,
wherein the evaluation device (20) is adapted to determine a prediction for the future course of wear of the electromechanical switching device (1000) based on the determined current state of wear and the mass data.

3. Device (100) according to claim 1 or 2,
wherein the device (100) is adapted to provide the mass data with an assignment to a respective state of the electromechanical switching device (1000);
wherein preferably the measuring device (10) comprises a processor.

4. Device (100) according to any one of the preceding claims,
wherein the measuring device (10) is further adapted to transmit via a data interface a data stream comprising the detected at least one predetermined operating parameter; wherein preferably the measuring device (10) is further adapted to be coupled to a power supply device and/or to be supplied with power via an actuation signal of the electromechanical switching device (1000).

5. Device (100) according to any one of the preceding claims,
wherein the device (100) has a plurality of measuring devices (10) and the evaluation device (20) is adapted to determine the current state of wear of a plurality of electromechanical switching devices (1000) based on a plurality of detected predetermined operating parameters.

6. Device (100) according to any one of the preceding claims,
wherein the evaluation device (20) is designed as a decentralized IT infrastructure distributed over a computer network, wherein the device (100) is also preferably adapted to transmit data on the current wear state to the electromechanical switching device (1000) via a transmission channel.

7. Device (100) according to any one of the preceding claims,
wherein the measuring device (10) is adapted to be integrated in a relay socket for the electromechanical switching device (1000); and/or
wherein the evaluation device (20) is adapted to be integrated in a relay socket for the electromechanical switching device (1000), wherein preferably the evaluation device (20) is further adapted to be used as a common head module for a plurality of measuring devices (10) integrated in further relay sockets for further electromechanical switching devices (1000).

8. Device (100) according to any one of the preceding claims,
wherein the device (100) further comprises a display device which is preferably adapted to display the current state of wear of the electromechanical switching device.

9. Device (100) according to any one of the preceding claims,
wherein the at least one predetermined operating parameter of the electromechanical switching device (1000) comprises an actuating force, a counterforce, an actuating travel, an overtravel, a switching point, a light pulse, an arc, an acoustic signal, a magnetic field, a temperature, a coil current, a coil voltage, a contact current, a load current or a contact voltage; and/or
wherein the mass data comprises any operating parameters and the any operating parameters comprise an actuating force, a counterforce, an actuating travel, an overtravel, a switching point, a light pulse, an arc, an acoustic signal, a magnetic field, a temperature, a coil current, a coil voltage, a contact current, a load current or a contact voltage of the electromechanical switching device (1000).

10. Device (100) according to any one of the preceding claims,
wherein the measuring device (10) is adapted to detect the any operating parameters as characteristic curves based on a preliminary measurement during an initialization phase of the electromechanical switching device (1000).

11. Device (100) according to any one of the preceding claims,
wherein the evaluation device (20) is adapted to use (i) a feature extraction from the mass data and/or (ii) a feature classification of the mass data in the machine deep learning.

12. Device (100) according to any one of the preceding claims,
wherein the evaluation device (20) comprises a neural network, a support vector machine, a classifier and/or a regressor.

13. Device (100) according to any one of the preceding claims,
wherein the evaluation device (20) is adapted to determine an individual wear curve of the electromechanical switching device (1000) based on a plurality of detected predetermined operating parameters and to infer a type parameter of the respective electromechanical switching device (1000) based thereon.

14. Device (100) according to any one of the preceding claims,
wherein the measuring device (10) is adapted to detect an environmental parameter of the electromechanical switching device (1000) and/or a type parameter of the electromechanical switching device (1000), preferably in the form of a manufacturer code;and
wherein the evaluation device (20) is adapted to determine the current state of wear of the electromechanical switching device (1000) based on the environmental parameter of the electromechanical switching device (1000) and/or the type parameter of the electromechanical switching device (1000).

15. Method for detecting wear of an electromechanical switching device (1000), the method comprising the following method steps:
- detecting (S1) of at least one predetermined operating parameter of the electromechanical switching device (1000) by means of a measuring device (10); and
- determining (S2) a current state of wear of the electromechanical switching device (1000) by means of a machine deep learning method with the aid of mass data, preferably in the form of training data, from(1 the recorded predetermined operating parameters of the electromechanical switching device (1000) by means of an evaluation device (20).

## Revendications

1. Dispositif (100) pour la détection d'usure d'un dispositif de commutation électromécanique (1000), lequel dispositif (100) comprend :
- un dispositif de mesure (10) conçu pour détecter au moins un paramètre de fonctionnement prédéterminé du dispositif de commutation électromécanique (1000) ; et
- un dispositif d'évaluation (20) conçu pour déterminer un état d'usure actuel du dispositif de commutation électromécanique (1000) au moyen d'un procédé d'apprentissage profond automatique à l'aide de données de masse, de préférence sous forme de données d'apprentissage, à partir du paramètre de fonctionnement prédéterminé détecté du dispositif de commutation électromécanique (1000).

2. Dispositif (100) selon la revendication 1,
dans lequel le dispositif d'évaluation (20) est conçu pour établir une prédiction de l'évolution future de l'usure du dispositif de commutation électromécanique (1000) sur la base de l'état d'usure actuel déterminé et des données de masse.

3. Dispositif (100) selon la revendication 1 ou 2,
dans lequel le dispositif (100) est conçu pour fournir les données de masse avec une association à un état respectif du dispositif de commutation électromécanique (1000) ;
dans lequel le dispositif de mesure (10) comporte de préférence un processeur.

4. Dispositif (100) selon l'une des revendications précédentes,
dans lequel le dispositif de mesure (10) est en outre conçu pour transmettre, par l'intermédiaire d'une interface de données, un flux de données comprenant le au moins un paramètre de fonctionnement prédéterminé détecté ; dans lequel le dispositif de mesure (10) est de préférence en outre conçu pour être couplé à un dispositif d'alimentation en énergie et/ou être alimenté en énergie par l'intermédiaire d'un signal de pilotage du dispositif de commutation électromécanique (1000).

5. Dispositif (100) selon l'une des revendications précédentes,
dans lequel le dispositif (100) comporte une pluralité de dispositifs de mesure (10) et le dispositif d'évaluation (20) est conçu pour déterminer l'état d'usure actuel d'une pluralité de dispositifs de commutation électromécaniques (1000) sur la base d'une pluralité de paramètres de fonctionnement prédéterminés détectés.

6. Dispositif (100) selon l'une des revendications précédentes,
dans lequel le dispositif d'évaluation (20) est conçu sous la forme d'une infrastructure IT décentralisée répartie sur un réseau d'ordinateurs, dans lequel le dispositif (100) est de préférence en outre conçu pour transmettre, par l'intermédiaire d'un canal de transmission, des données sur l'état d'usure actuel au dispositif de commutation électromécanique (1000).

7. Dispositif (100) selon l'une des revendications précédentes,
dans lequel le dispositif de mesure (10) est conçu pour être intégré dans une embase de relais pour le dispositif de commutation électromécanique (1000) ; et/ou
dans lequel le dispositif d'évaluation (20) est conçu pour être intégré dans une embase de relais pour le dispositif de commutation électromécanique (1000), dans lequel le dispositif d'évaluation (20) est de préférence en outre conçu pour être utilisé comme un module de tête commun pour une pluralité de dispositifs de mesure (10) intégrés dans des embases de relais supplémentaires pour des dispositifs de commutation électromécaniques (1000) supplémentaires.

8. Dispositif (100) selon l'une des revendications précédentes,
dans lequel le dispositif (100) comprend en outre un dispositif d'affichage qui est de préférence configuré pour afficher l'état d'usure actuel du dispositif de commutation électromécanique.

9. Dispositif (100) selon l'une des revendications précédentes,
dans lequel le au moins un paramètre de fonctionnement prédéterminé du dispositif de commutation électromécanique (1000) comprend une force d'actionnement, une force de réaction, une course d'actionnement, une surcourse, un point de commutation, une impulsion lumineuse, un arc électrique, un signal acoustique, un champ magnétique, une température, un courant de bobine, une tension de bobine, un courant de contact, un courant de charge ou une tension de contact ; et/ou
dans lequel les données de masse comprennent des paramètres de fonctionnement quelconques et les paramètres de fonctionnement quelconques comprennent une force d'actionnement, une force de réaction, une course d'actionnement, une surcourse, un point de commutation, une impulsion lumineuse, un arc électrique, un signal acoustique, un champ magnétique, une température, un courant de bobine, une tension de bobine, un courant de contact, un courant de charge ou une tension de contact du dispositif de commutation électromécanique (1000).

10. Dispositif (100) selon l'une des revendications précédentes,
dans lequel le dispositif de mesure (10) est conçu pour détecter les paramètres de fonctionnement quelconques sous forme de courbes caractéristiques sur la base d'une mesure préalable au cours d'une phase d'initialisation du dispositif de commutation électromécanique (1000).

11. Dispositif (100) selon l'une des revendications précédentes,
dans lequel le dispositif d'évaluation (20) est conçu pour utiliser, pendant l'apprentissage profond automatique, (i) une extraction de caractéristiques à partir des données de masse et/ou (ii) une classification de caractéristiques des données de masse.

12. Dispositif (100) selon l'une des revendications précédentes,
dans lequel le dispositif d'évaluation (20) comporte un réseau neuronal, une machine à vecteurs de support, un classificateur, et/ou une variable explicative.

13. Dispositif (100) selon l'une des revendications précédentes,
dans lequel le dispositif d'évaluation (20) est conçu pour déterminer, sur la base d'une pluralité de paramètres de fonctionnement prédéterminés détectés, une courbe d'usure individuelle du dispositif de commutation électromécanique (1000) et pour établir une conclusion sur la base d'un paramètre de type du dispositif de commutation électromécanique (1000) respectif.

14. Dispositif (100) selon l'une des revendications précédentes,
dans lequel le dispositif de mesure (10) est conçu pour détecter un paramètre d'environnement du dispositif de commutation électromécanique (1000) et/ou un paramètre de type du dispositif de commutation électromécanique (1000), de préférence sous la forme d'un code de fabricant ; et
dans lequel le dispositif d'évaluation (20) est conçu pour déterminer, sur la base du paramètre d'environnement du dispositif de commutation électromécanique (1000) et/ou du paramètre de type du dispositif de commutation électromécanique (1000), l'état d'usure actuel du dispositif de commutation électromécanique (1000).

15. Procédé de détection d'usure d'un dispositif de commutation électromécanique (1000), dans lequel le procédé comprend les étapes suivantes :
- détecter (S1) au moins un paramètre de fonctionnement prédéterminé du dispositif de commutation électromécanique (1000) au moyen d'un dispositif de mesure (10) ; et
- déterminer (S2), au moyen d'un dispositif d'évaluation (20), un état d'usure actuel du dispositif de commutation électromécanique (1000) par un procédé d'apprentissage profond automatique à l'aide de données de masse, de préférence sous forme de données d'apprentissage, à partir du paramètre de fonctionnement prédéterminé détecté du dispositif de commutation électromécanique (1000).
